(19) Europäisches Patentamt
European Patent Office
Office européen des brevets

(11) **EP 2 009 797 A1**

(12) **EUROPEAN PATENT APPLICATION**
published in accordance with Art. 153(4) EPC

(43) Date of publication:
**31.12.2008 Bulletin 2009/01**

(51) Int Cl.:
*H03L 7/183* (2006.01)   *H04L 27/34* (2006.01)

(21) Application number: **07737812.3**

(22) Date of filing: **06.03.2007**

(86) International application number:
**PCT/JP2007/054237**

(87) International publication number:
**WO 2007/102478 (13.09.2007 Gazette 2007/37)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **07.03.2006 JP 2006060832**

(71) Applicant: **Panasonic Corporation**
**Kadoma-shi**
**Osaka 571-8501 (JP)**

(72) Inventors:
• **YOSHIDA, Seiichiro**
**Chuo-ku, Osaka-shi**
**Osaka 540-6207 (JP)**
• **HAYASHI, Joji**
**Chuo-ku, Osaka-shi**
**Osaka 540-6207 (JP)**

(74) Representative: **Eisenführ, Speiser & Partner**
**Patentanwälte Rechtsanwälte**
**Postfach 10 60 78**
**28060 Bremen (DE)**

(54) **FREQUENCY SYNTHESIZER, WIRELESS COMMUNICATION SYSTEM, AND SEMICONDUCTOR DEVICE**

(57)   In transmission frequency modulation in radio communication, correspondences to multiple-value frequency modulation having plural-bits transmission data are realized while suppressing an increase in the circuit area. When performing transmission frequency modulation in radio communication, response data of a digital filter are calculated by a logic circuit that is embedded in a transmission modulator. Since a change amount in the division number is calculated by the logic circuit, a ROM for storing the response data is dispensed with, and thereby an increase in the circuit area can be suppressed when the transmission modulator corresponds to variations in the frequency of a reference signal or to multiple-value frequency modulation having plural-bits transmission data. Further, bandwidth narrowing of a transmission signal spectrum is realized by performing the transmission frequency modulation with dividing the process thereof into plural steps using a timing synchronized with a clock.

Fig.1(a)

**EP 2 009 797 A1**

**Description**

FIELD OF THE INVENTION

The present invention relates to a frequency synthesizer, a radio communication system, and a semiconductor device which perform transmission frequency modulation in radio communication, and more particularly, to a technique that is effective for a high performance and a reduction in circuit area.

BACKGROUND ART

A frequency synthesizer is constituted such that the phase of a frequency-divided signal which is obtained by dividing the frequency of an output of a voltage-controlled oscillator that oscillates with a frequency corresponding to an inputted control voltage, by a division number set in a variable frequency divider is compared with the phase of a reference signal for comparison by a phase comparator, and then a phase difference signal that is outputted according to the magnitude of the phase difference is fed back as a control voltage for the voltage-controlled oscillator, whereby the frequency synthesizer goes into a stationary state where the frequency of the frequency-divided signal matches the frequency of the reference signal, resulting in a frequency-synchronized state.

At this time, the frequency of the output signal of the frequency synthesizer becomes equal to one obtained by multiplying the frequency of the frequency-divided signal by the division number, i.e., one obtained by multiplying the frequency of the reference signal by the division number, and thus an output signal having a desired frequency can be obtained by this method.

Since the output frequency of the frequency synthesizer is determined by the division number of the variable frequency divider when the frequency of the reference signal is made constant, a method of varying the division number of the variable frequency divider according to the transmission data is generally adopted at performing transmission frequency modulation.

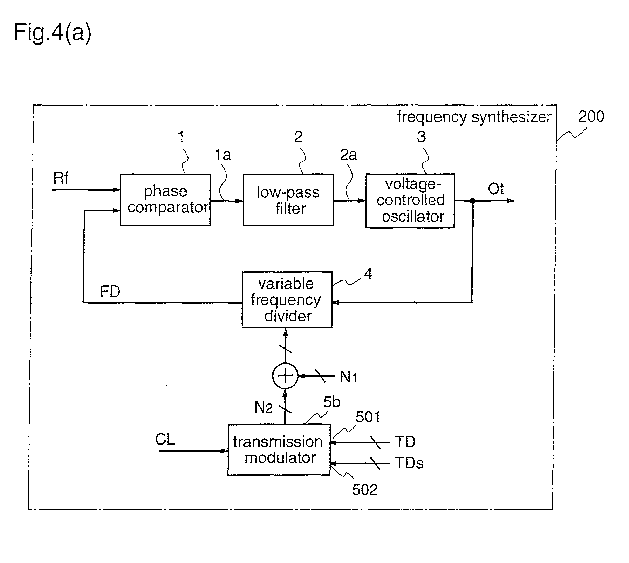

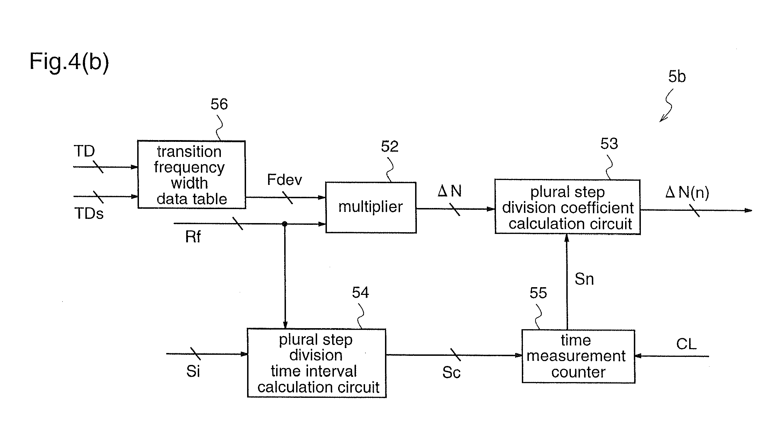

As a method for changing the division number of the variable frequency divider, there is proposed a method as described in IEEE FOURNAL OF SOLID-STATE CIRCUITS, Vol.33, No.7, July 1998, pp.998, Fig.4, "An Agile ISM Band Frequency Synthesizer with Built-in GMSK Data Modulation". In the method described in this literature, the pulse response data of a digital filter corresponding to variations in the transmission data are previously stored in a ROM (Read Only Memory) unit, and the data which is read from the ROM according to a variation in the transmission data is treated as a division number change amount and added to a set division number, thereby realizing frequency modulation.

Non-Patent Document: IEEE FOURNAL OF SOLID-STATE CIRCUITS, Vol.33, No.7, July 1998, pp.998, An Agile ISM Band Frequency Synthesizer with Built-in GMSK Data Modulation

DISCLOSURE OF THE INVENTION

PROBLEMS TO BE SOLVED BY THE INVENTION

The conventional frequency synthesizer performing the frequency modulation in the radio communication is constituted as described above, and it realizes the frequency modulation by reading out the pulse response data of the digital filter which are previously stored in the ROM to be treated as a division number change amount, and adding the same to the division number corresponding to the center frequency.

In the conventional method, however, since all the pulse response data corresponding to the variations in the transmission data are stored in the ROM, the ROM capacity is significantly increased with an increase in the correspondence number corresponding to the various frequencies of the reference signal or the correspondence number corresponding to the frequency change widths with respect to the transmission data, and further, the circuit for reading out the data from the ROM is also increased, resulting in an unavoidable increase in the circuit area.

The present invention is made to solve the above-described problems and has for its object to provide a frequency synthesizer, a radio communication system, and a semiconductor device, which perform the transmission frequency modulation that can flexibly correspond to the various frequencies of the reference signal and the frequency change widths with respect to the transmission data, and can correspond to the multiple-value frequency modulation having plural-bits transmission data, while minimizing an increase in the circuit area.

MEASURES TO SOLVE THE PROBLEMS

In order to achieve the above-described object, a frequency synthesizer according to the present invention is provided with a transmission modulator which is a circuit block for calculating a division number change amount using a logic circuit.

More specifically, the frequency synthesizer according to the present invention is provided with a voltage-controlled oscillator which generates a signal having a frequency corresponding to an inputted control voltage, a variable frequency divider which frequency-divides the output signal from the voltage-controlled oscillator according to inputted division number data to output the frequency-divided signal, a phase comparator which compares the phase of the output signal from the variable frequency divider with the phase of an inputted reference signal to output a signal indicating the comparison result, and a low-pass filter which low-pass-filters the signal from the phase comparator to output the filtered signal as the control voltage for the voltage-controlled oscillator, and further, a transmission modulator which calculates a division number change amount of the variable frequency divider in accordance with the inputted transmission data, and adds the calculated division number change amount to a division number set value of a center frequency, thereby performing frequency modulation.

In the above-described construction, since the change amount in the division number is calculated by the logic circuit in the transmission modulator, when the frequency of the reference signal is varied to 2 times or 1/2 time, the change amount in the division number can be easily calculated by only performing a bit shift, thereby suppressing an increase in the circuit area.

Further, also when increasing the correspondence number corresponding to the frequency change widths with respect to the variations in the transmission data, by setting the intervals between the frequency change widths constant, the change amount in the division number can be efficiently calculated using a multiplier, thereby suppressing an increase in the circuit area in contrast to the case where all of the pulse response data are stored in a ROM.

As the correspondence number corresponding to the frequencies of the reference signal or the correspondence number corresponding to the frequency change widths with respect to the transmission data becomes larger, these circuit area reduction effects become more remarkable.

Furthermore, the transmission modulator, provided with a clock signal input terminal, performs the frequency division with dividing the frequency division process into plural steps using a clock signal supplied from the clock signal input terminal, and then calculates the division number change amounts corresponding to the respective steps, whereby bandwidth narrowing of the transmission frequency spectrum can be achieved.

EFFECTS OF THE INVENTION

Since the frequency synthesizer of the present invention has the above-described construction, it is possible to realize a transmission modulation frequency synthesizer having a higher performance with a smaller-scale circuit, as compared with the conventional art.

BRIEF DESCRIPTION OF THE DRAWINGS

Figure 1(a) is a block diagram illustrating the construction of a frequency synthesizer 100 according to a first embodiment of the present invention.

Figure 1(b) is a diagram illustrating a specific construction of a transmission modulator 5a in the frequency synthesizer according to the first embodiment of the present invention.

Figure 2(a) is a diagram for explaining the process of frequency change in the frequency synthesizer 100 according to the first embodiment of the present invention.

Figure 2(b) is a diagram for explaining the process of frequency change in the frequency synthesizer 100 according to the first embodiment of the present invention.

Figure 3(a) is a transmission signal spectrum diagram which indicates the effect achieved when the frequency modulation process is performed with dividing the same into plural steps, in the frequency synthesizer 100 according to the first embodiment of the present invention.

Figure 3(b) is a transmission signal spectrum diagram which indicates the effect achieved when the frequency modulation process is performed with dividing the same into plural steps, in the frequency synthesizer 100 according to the first embodiment of the present invention.

Figure 4(a) is a block diagram illustrating the construction of a frequency synthesizer 200 according to a second embodiment of the present invention.

Figure 4(b) is a diagram illustrating a specific construction of a transmission modulator 5b in the frequency synthesizer 200 according to the second embodiment of the present invention.

Figure 5 is a diagram illustrating the manner of 4-value FSK frequency modulation in the frequency synthesizer 200 according to the second embodiment of the present invention.

Figure 6(a) is a block diagram illustrating the construction of a frequency synthesizer 300 according to a third embodiment of the present invention.

Figure 6(b) is a diagram illustrating a specific construction of a transmission modulator 5c in the frequency synthesizer 300 according to the third embodiment of the present invention.

Figure 7(a) is a block diagram illustrating the construction of a frequency synthesizer 400 according to a fourth embodiment of the present invention.

Figure 7(b) is a diagram illustrating a specific construction of a transmission modulator 5d in the frequency synthesizer 400 according to the fourth embodiment of the present invention.

Figure 8 is a diagram illustrating a transmission data sequence in the frequency synthesizer 400 according to the fourth embodiment of the present invention.

Figure 9 is a diagram illustrating the relationship between the transmission data sequence and the transmission data clock in the frequency synthesizer 400 according to the fourth embodiment of the present invention.

Figure 10 is a block diagram illustrating the construction of a frequency synthesizer 500 according to a fifth embodiment of the present invention.

Figure 11 is a block diagram illustrating the construction of a radio communication system 600 according to a sixth embodiment of the present invention.

Figure 12 is a block diagram illustrating the construction of a radio communication system 700 according to a seventh embodiment of the present invention.

Figure 13 is a block diagram illustrating the construction of a radio communication system 800 according to an eighth embodiment of the present invention.

DESCRIPTION OF REFERENCE NUMERALS

1      ... phase comparator
2      ... low-pass filter
3      ... voltage-controlled oscillator
4      ... variable frequency divider
5      ... transmission modulator
6      ... sigma-delta modulator
7      ... transmission data generator
8      ... power amplifier
9      ... transmission antenna
10     ... reception antenna
11     ... reception circuit
12     ... transmission/reception switch
13     ... transmission/reception antenna

BEST MODE TO EXECUTE THE INVENTION

Hereinafter, embodiments of the present invention will be described with reference to the drawings. The embodiments described hereinafter are merely examples, and the present invention is not necessarily restricted to these embodiments.

(Embodiment 1)

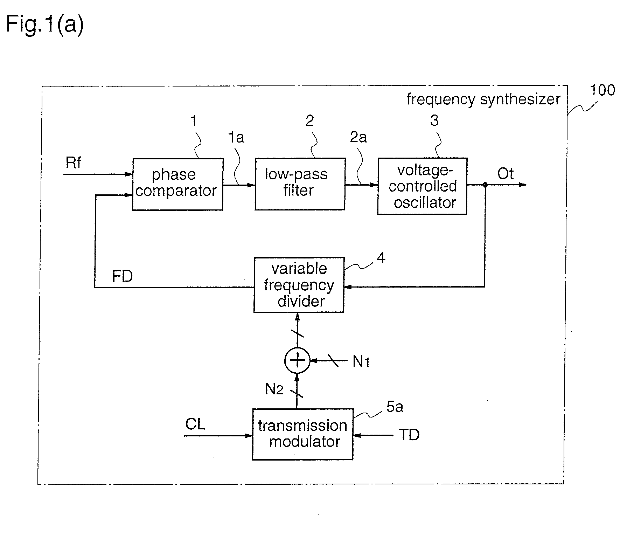

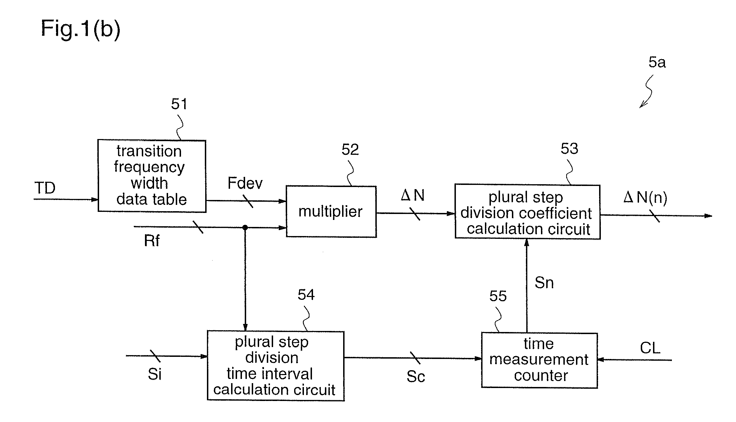

Figure 1 shows the construction of a frequency synthesizer 100 according to a first embodiment of the present invention.

In figure 1, reference numeral 1 denotes a phase comparator, numeral 2 denotes a low-pass filter, numeral 3 denotes a voltage-controlled oscillator, numeral 4 denotes a variable frequency divider, and numeral 5a denotes a transmission modulator.

Further, Rf denotes a reference signal, Ot denotes an output signal, FD denotes a frequency-divided signal, N1 denotes division number data, N2 denotes a division number change amount, CL denotes a clock signal, and TD denotes transmission data.

Next, the operation of the frequency synthesizer of this first embodiment will be described.

An output signal Ot of the voltage-controlled oscillator which generates an output signal having a frequency corresponding to an inputted control voltage is outputted as an output signal of the frequency synthesizer 100 and, simultaneously, inputted to the variable frequency divider 4. The variable frequency divider 4 frequency-divides the output signal Ot according to inputted division number data N1, and outputs the same as a frequency-divided signal FD.

Assuming that the division number data N1 is N,

$$\text{(frequency-divided signal frequency)} = \text{(output signal frequency)}/N$$

wherein the division number data N is not limited to an integer, and it may be a numeral value including a decimal part.

The phase comparator 1 compares the phase of an inputted reference signal Rf with the phase of the frequency-divided signal FD, and generates and outputs a signal 1a indicating the comparison result. The signal 1a indicating the comparison result is low-pass-filtered by passing through the low-pass filter 2, and the filtered signal is inputted (fed back) to the voltage-controlled oscillator 3 as its control signal 2a. By constituting such feedback system, the phase and frequency of the reference signal Rf are matched to those of the frequency-divided signal FD in the stationary state, and therefore,

$$\text{(reference signal frequency)} = \text{(output signal frequency)}/N$$

that is,

$$\text{(output signal frequency)} = \text{(reference signal frequency)} \times N$$

The above is the operation principle of the fundamental frequency synthesizer.

The frequency synthesizer 100 of this first embodiment is characterized by that the fundamental frequency synthesizer is provided with the transmission modulator 5a to realize transmission frequency modulation.

When performing binary frequency modulation, the transmission data TD which is 0 or 1 is input to the transmission modulator 5a, and it has previously been determined how much degree the output frequency should be changed from the center frequency in response to each transmission data. When the frequency change amount from the center frequency according to the transmission data TD is defined as Fdev,

$$\text{Fdev} = \text{(reference signal frequency)} \times \Delta N$$

wherein $\Delta N$ is the division number change amount according to the transmission data TD, and usually, it is a number including digits after a decimal point. That is, according to the value of the transmission data TD,

$$\Delta N = \text{Fdev}/\text{(reference signal frequency)}$$

is calculated by a logic circuit in the transmission modulator 5a. For example, when a case where the output frequency increases by +Fdev is considered, this division number change amount is added to the division number data that specifies the center frequency, and the resultant is inputted to the variable frequency divider 4, whereby

$$\text{(output signal frequency)} = \text{(reference signal frequency)} \times (N + \Delta N)$$
$$= \text{(reference signal frequency)} \times \{N + \text{Fdev}/\text{(reference signal frequency)}\}$$
$$= \{\text{(reference signal frequency)} \times N\} + \text{Fdev}$$

is obtained, and thereby the frequency which is changed by +Fdev from the center frequency according to the transmission data is outputted, and thus the transmission frequency modulation is realized. When the division number change amount is -ΔN, the frequency which is changed by -Fdev from the center frequency is outputted.

The frequency modulation realized by the present invention includes not only the frequency modulation (FM) for transmitting analog data but also the frequency shift keying (FSK) that is a frequency modulation method corresponding to digital value transmission data.

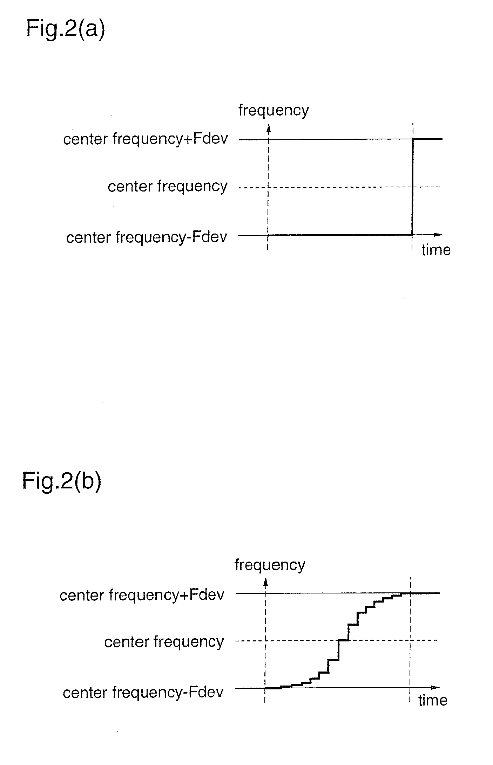

Further, the frequency change due to the change in the transmission data, i.e., the division number change, is not limited to the change that is completed in one time (step) as shown in figure 2(a). As shown in figure 2(b), the division number change may be divided into plural steps, and the division number change amounts corresponding to the respective steps may be calculated, thereby to narrow the bandwidth of the transmission frequency spectrum.

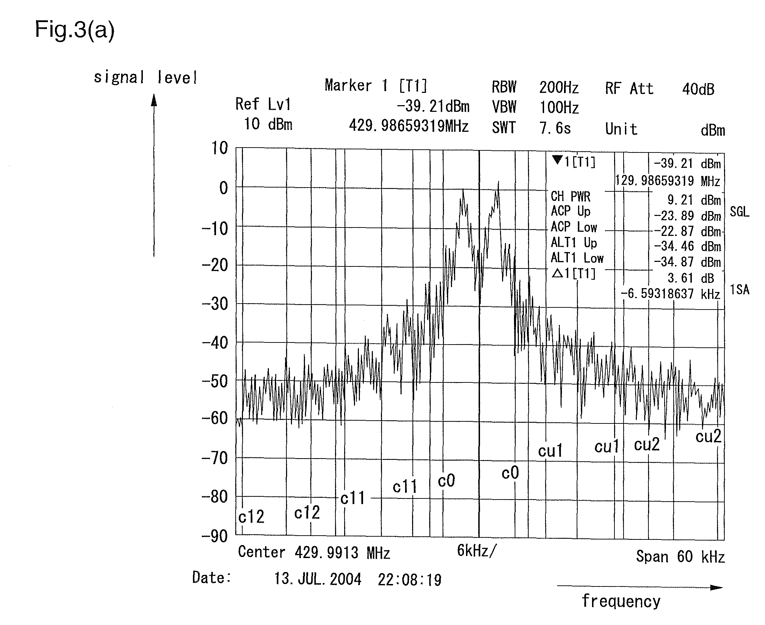

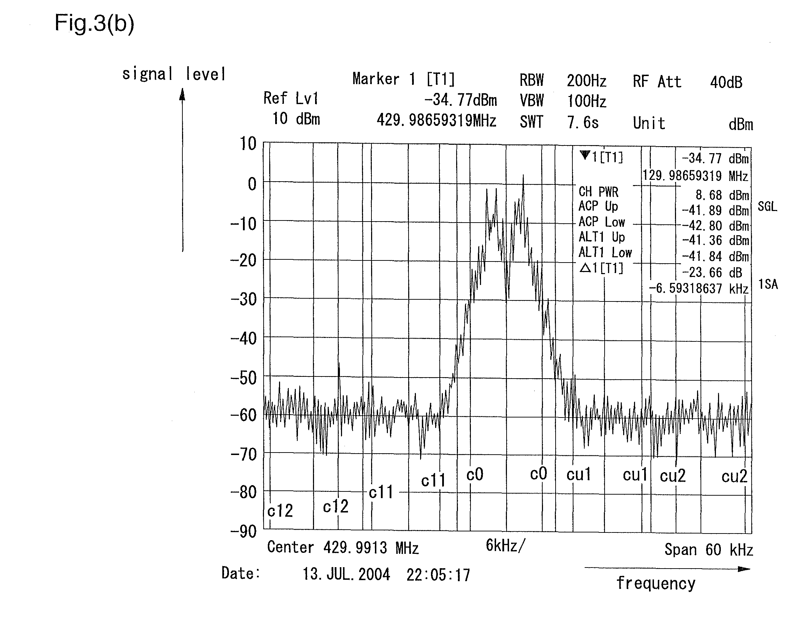

Figure 3(a) shows the transmission frequency spectrum in the case where the frequency change is completed in one time as shown in figure 2(a), and figure 3(b) shows the transmission frequency spectrum in the case where the frequency change is divided into plural steps (16 steps in the figure) as shown in figure 2(b).

The evaluation conditions are as follows: output frequency of 430MHz, Fdev=2, transmission data rate of 2400bps, and binary FSK modulation. The spreading of the spectrum toward the adjacent frequency is apparently suppressed in figure 3(b) in comparison with figure 3(a), and thus it is found that bandwidth narrowing is achieved.

Since, in the radio communication, leakage of the transmission signal to the adjacent channel causes a false operation which would lead to a very serious problem, the transmission frequency spectrum must be narrowed in its bandwidth as much as possible. So, it can be said that the method of dividing the frequency change due to the change in the transmission data into plural steps and then calculating the division number change amounts corresponding to the respective steps as in the present invention is a requisite method in the radio communication using the transmission frequency modulation.

While it is known that the effect of the bandwidth narrowing of the transmission frequency spectrum is higher as the number of the divided steps is larger, there simultaneously occurs a problem that the circuit area is undesirably increased. Thus, the effect of the bandwidth narrowing and the circuit area are in the trade-off relationship. However, since the effect of the bandwidth narrowing is weakened when exceeding 16 steps, it is optimum to divide the frequency change into 16 steps. The number of steps of the frequency changes is not particularly restricted.

Further, while it is considered that the effect of the bandwidth narrowing is enhanced when the shape of the waveform obtained by connecting the respective frequency points is a GFSK or sinusoidal waveform, the type of the waveform is not particularly restricted, and an optimum waveform is selected according to the allowable speck of the system.

Further, it is necessary to input a clock signal in order to determine the time intervals of the respective steps, and the time intervals can be measured more accurately when using a clock signal having a constant frequency. While it is considered that, as a clock signal having a constant frequency, the reference signal of the frequency synthesizer or the reference signal that is divided into appropriate frequencies is optimum, the clock signal is not particularly restricted, and even a signal whose frequency is not constant but continuously changes can be used as a clock signal.

Furthermore, the time intervals of the respective steps until the change in the frequency with the change in the transmission data is completed are not necessarily the same. For example, the time intervals of the respective steps may be set such that a fine time interval is set at a position where the frequency change amount is large while a large time interval is set at a position where the frequency change amount is small.

Next, a specific example of the transmission modulator 5a in the frequency synthesizer of the first embodiment will be described.

Figure 1(b) is a diagram illustrating a specific construction of the transmission modulator 5a in the frequency synthesizer of the first embodiment. In figure 1(b), reference numeral 51 denotes a transition frequency width data table, numeral 52 denotes a multiplier, numeral 53 denotes a plural step division coefficient calculation circuit, numeral 54 denotes a plural step division time interval calculation circuit, and numeral 55 denotes a time measurement counter.

The transition frequency width data table 51 outputs a transition frequency width that is previously set according to the signal of the transmission data TD which is "0" or "1". Since the transition frequency width is always constant, for example, it is -Fdev when the signal is "0" and Fdev when the signal is "1". This transition frequency width indicates a frequency difference between the oscillation frequency before transition and the oscillation frequency corresponding to the transmission data. Next, the multiplier 52 calculates a division number change amount ΔN. The specific calculation formula is as follows:

```
division number change amount  ΔN = transition frequency width Fdev/reference signal frequency
```

Subsequently, in order to divide this division change amount into plural steps to be outputted, the plural step division coefficient calculation circuit 53 calculates division number change amounts $\Delta N(n)$ in the respective steps. To be specific, the values obtained by multiplying the division number change amounts $\Delta N$ by predetermined coefficients $x1, x2, ...,$ such as $\Delta N(1)=x1\Delta N, \Delta N(2)=x2\Delta N, ...$ , are outputted as the division number change amounts $\Delta N(n)$ in the respective steps. Further, in the plural steps, the time interval until each step transits to the next step is measured by the time measurement counter 55. The time measurement counter 55 counts the clock signal (usually, the reference signal CL of the synthesizer), and outputs a next step transition command signal Sn to the plural step division coefficient calculation circuit 53 when the count value matches a preset count end value. A plural step division time interval count end value Sc is calculated by the plural step division time interval calculation circuit 54 on the basis of the reference signal frequency Rf and the plural step division time interval specifying signal Si. Since, when the reference signal frequency Rf changes, the count value until a certain time is measured also changes, the reference signal frequency Rf is also inputted to the plural step division time interval calculation circuit 54.

Through the above-described operation, the transmission modulator 5a divides the division number change amount according to the transmission data TD into plural steps, and outputs the same.

Also in the conventional art, such bandwidth narrowing of the transmission frequency spectrum has been performed by storing the division number change amounts in the respective steps into the ROM. In this method, however, since the required ROM capacity is increased in proportion to the increase in the number of steps, an increase in the circuit area cannot be avoided.

On the other hand, in the frequency synthesizer of this first embodiment, the change amounts in the division number are calculated by the logic circuit in the transmission modulator 5a. Therefore, in contrast to the conventional method of reading out the pulse response data from the ROM, not only the ROM but also the readout circuit for reading out the data from the ROM with specifying addresses or the like are dispensed with, thereby significantly suppressing an increase in the circuit area.

Furthermore, there is a case where it is necessary to make the frequency synthesizer correspond to the various frequencies of the reference signal in order to deal with various crystal oscillators. In this first embodiment, for example, when the frequency of the reference signal is varied to 2 times or 1/2 time, the change amount in the division number can be easily calculated by only performing a bit shift in the transmission modulator 5a, and also in such case, an increase in the circuit area can be significantly suppressed.

As described above, the frequency synthesizer 100 according to this first embodiment is provided with the voltage-controlled oscillator, the variable frequency divider, the phase comparator which compares the phase of the output signal from the variable frequency divider with the phase of the inputted reference signal to output a signal indicating the comparison result, and the low-pass filter which low-pass-filters the signal outputted from the phase comparator to output the filtered signal as a control voltage for the voltage-controlled oscillator, and further, the transmission modulator which calculates a division number change amount of the variable frequency divider in accordance with the inputted transmission data, and adds the calculated division number change amount to the division number set value of the center frequency, thereby performing frequency modulation. Therefore, in contrast to the conventional case of reading out the pulse response data from the ROM, the ROM unit and the readout circuit for reading out the data from the ROM with specifying addresses or the like are dispensed with, thereby significantly suppressing an increase in the circuit area.

Further, also when realizing the correspondences to the various frequencies of the reference signal according to various crystal oscillators, the change amounts in the division number for obtaining the different frequencies of the reference signal can be easily calculated by only performing bit shifts in the transmission modulator, thereby obtaining the effect of significantly suppressing an increase in the circuit area.

(Embodiment 2)

Figure 4 is a diagram illustrating the construction of a frequency synthesizer 200 according to a second embodiment of the present invention.

This second embodiment is characterized by that, in contrast to the first embodiment, the transmission data input terminal 501 of the transmission modulator 5b to which the transmission data TD is inputted is not a 1-bit input terminal but a plural-bit input terminal, and the transmission modulator 5b is provided with an input terminal 502 to which a transmission data value setting signal TDs is inputted.

In the radio communication, the transmission data rate is increased as the number of symbols is larger, and thereby highly efficient data transmission is achieved. However, since plural patterns of frequency changes exist in the multiple-bit transmission modulation, the division number change amounts as many as the number of the frequency change patterns must be stored in the ROM in the conventional method of reading out the pulse response data from the ROM. Accordingly, the conventional method has a problem that an enormous ROM capacity is required.

On the other hand, in this second embodiment, the change amount in the division number is calculated by the logic circuit in the transmission modulator 5b, and in the usual multiple-value frequency modulation, the frequency difference corresponding to the adjacent transmission data is constant. Therefore, in this second embodiment, by only integer-multiplying the calculated division number change amount, the division change amounts corresponding to the modulation patterns of the respective transmission data values can be efficiently calculated with a small-scale circuit area.

Figure 4(b) is a diagram illustrating the specific construction of the transmission modulator 5b in the frequency synthesizer according to the second embodiment. In the figure, the same reference numerals as those shown in figure 1(b) denote the same or corresponding parts. Further, reference numeral 56 denotes a transition frequency width calculation circuit.

The transmission data TD is inputted not as a 1-bit signal but as a multiple-bit signal to the transmission modulator 5b in the frequency synthesizer of this second embodiment. The transition frequency width calculation circuit 56 calculates a transition frequency width Fdev on the basis of the transmission data TD and the transmission data value setting signal TDs, and outputs the same. Since the operation after the calculation of the transition frequency width Fdev is identical to the operation of the transmission modulator 5a in the frequency synthesizer of the first embodiment shown in figure 1(b), repeated description is not necessary.

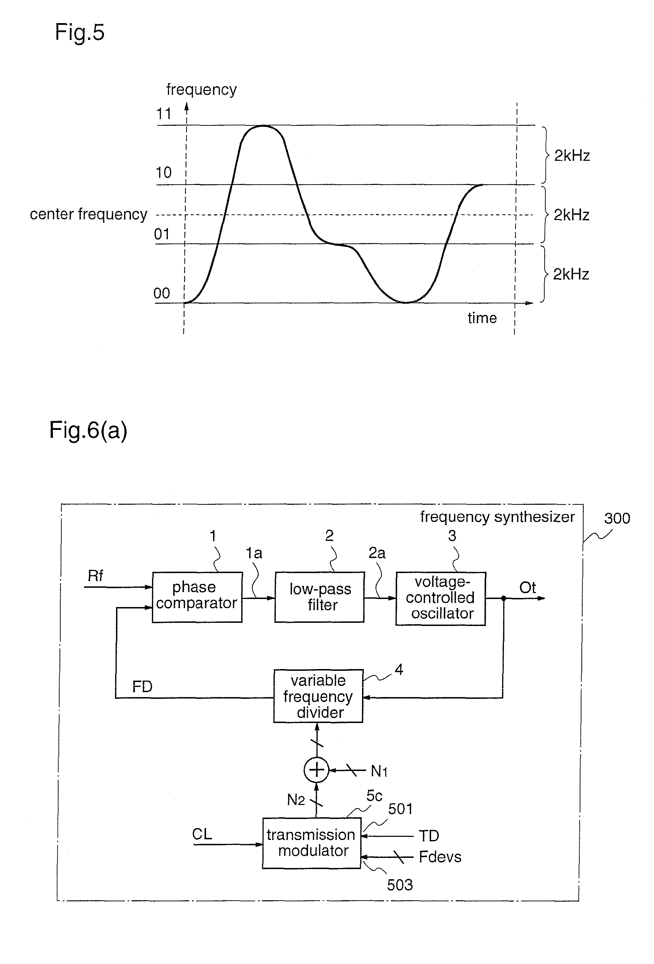

For example, as shown in figure 5, when the four-value FSK is adopted, there are four types of transmission data values 00, 01, 10, and 11. Assuming that the frequency difference corresponding to the adjacent data is 2kHz, when the data value transits from 00 to any other data value, the frequency difference becomes an integer multiple of 2kHz. Accordingly, the division number change value also becomes an integer multiple based on a certain value, and thereby the circuit scale required for the calculation can be significantly reduced. On the other hand, in the conventional method using the ROM, the effect of such area reduction cannot be obtained, and the circuit area is further increased with an increase in the number of bits of the transition data.

The correspondence relationship between the transmission data values and the frequencies shown in figure 5 is merely an example, and it is not necessary to comply with this correspondence relationship.

Further, while the transmission modulator performing the frequency modulation for four values is described above, the present invention is also applicable to a transmission modulator which performs transmission frequency modulation having three, five or more transmission data values.

Further, by changing the number of the transmission data values with the transmission data value setting input terminal 52, it is possible to appropriately perform switching from 4 values to 2 values, or from 2 values to 4 values, or to other transmission data values, and thereby switching of the communication speed can be immediately and easily performed.

According to the frequency synthesizer 200 of this second embodiment, the transmission modulator is provided with the transmission data input terminal which receives a multiple-bit input, and the transmission data value setting input terminal for setting the transmission data values. Therefore, in the multiple-bit transmission modulation in which the transmission data rate is increased with an increase in the number of symbols and thereby highly-efficient data transmission is realized, the frequency synthesizer of this second embodiment can perform the operation of the multiple-bit transmission modulation by only integer-multiplying the division number change amount using the logic circuit in the transmission modulator 5b, and thereby the correspondence to the multiple-value frequency modulation can be realized while significantly suppressing an increase in the circuit area, while the conventional method of reading out the pulse response data from the ROM requires an enormous ROM capacity corresponding to the number of the frequency change patterns.

(Embodiment 3)

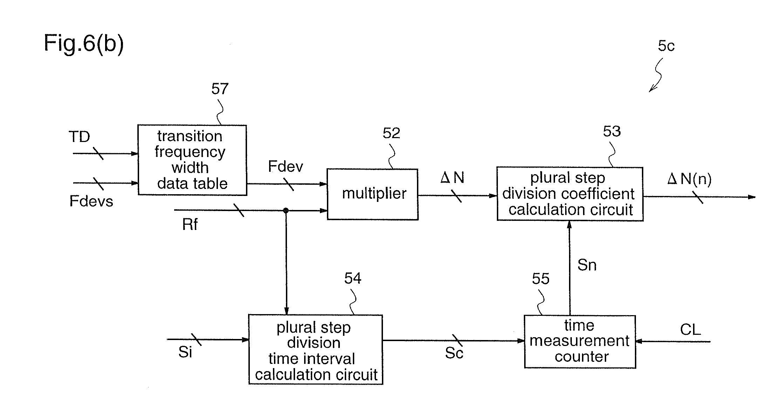

Figure 6 is a diagram illustrating the construction of a frequency synthesizer 300 according to a third embodiment of the present invention.

This third embodiment is characterized by that, in contrast to the first embodiment, a transmission modulator 5c is provided with a 1-bit or multiple-bit input terminal 503 to which a Fdev setting signal Fdevs for setting a frequency change amount Fdev is inputted.

In the conventional method of reading out the pulse response data from the ROM, when the frequency change amount corresponding to the transmission data is made variable, a large ROM capacity is required in proportion to the number of the varied frequency change amounts, resulting in a considerable increase in the circuit area.

Since the frequency synthesizer 300 including the transmission modulator according to the third embodiment calculates a division number change amount by a logic circuit, it can efficiently calculate the division number change amount with a reduced circuit area by commonizing the logic circuit. Accordingly, it is possible to make the frequency change amount corresponding to the transmission data variable while suppressing an increase in the circuit area.

Figure 6(b) is a diagram illustrating a specific construction of the transmission modulator 5c of the frequency synthesizer according to the third embodiment. In the figure, the same reference numerals as those shown in figure 1(b) denote the same or corresponding parts. Further, reference numeral 57 denotes a transition frequency width calculation circuit.

The transmission data TD and the Fdev setting signal Fdevs for setting a frequency change amount Fdev are input to the transmission modulator 5b of the frequency synthesizer of this third embodiment. The transition frequency width calculation circuit 57 calculates a transition frequency width Fdev on the basis of the inputted transmission data TD and Fdev setting signal Fdevs, and outputs the same. Since the subsequent operation is identical to that of the transmission modulator 5a in the frequency synthesizer of the first embodiment shown in figure 1(b), repeated description is not necessary.

According to the frequency synthesizer 300 of this third embodiment, in contrast to the first embodiment, the transmission modulator 5c is provided with the 1-bit or plural-bit input terminal for setting the frequency change amount Fdev. In the conventional method of reading out the pulse response data from the ROM, when the frequency change amount corresponding to the transmission data is made variable, a large ROM capacity is required in proportion to the number of the varied frequency change amounts, resulting in a considerable increase in the circuit area. In this third embodiment, however, since the change amount in the division number is calculated by the logic circuit in the transmission modulator 5c, the frequency change amount can be efficiently calculated with a reduced circuit area by commonizing the logic circuit, and thus the frequency change amount corresponding to the transmission data can be made variable while suppressing an increase in the circuit area.

(Embodiment 4)

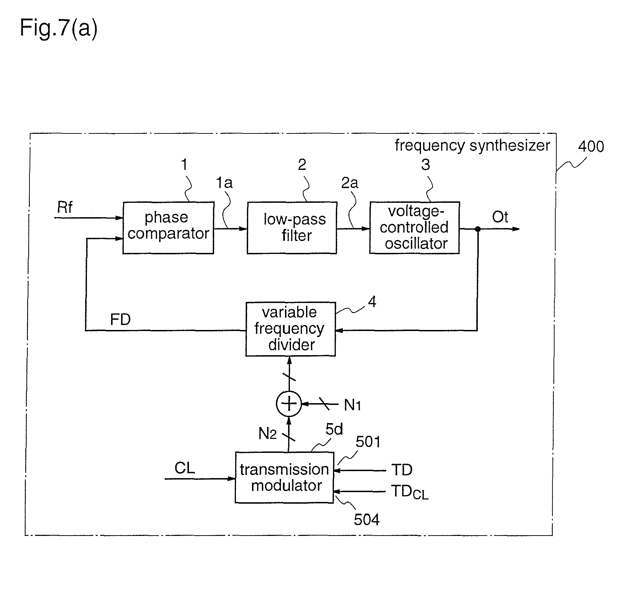

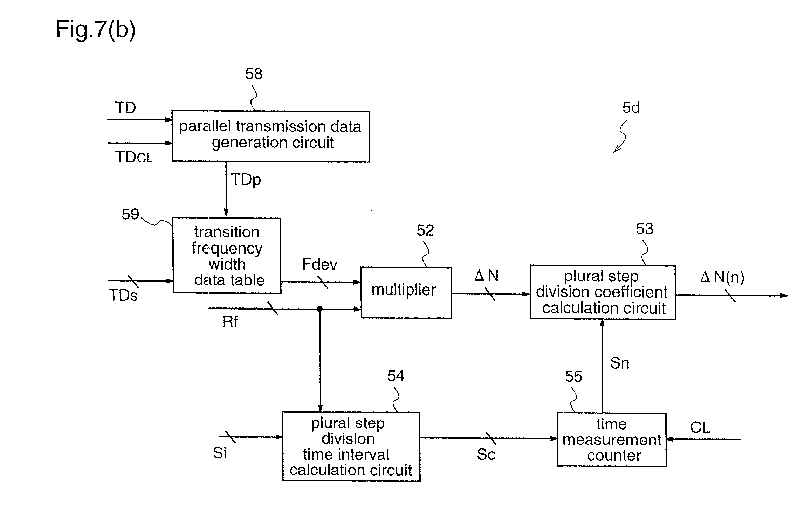

Figure 7 is a diagram illustrating the construction of a frequency synthesizer 400 according to a fourth embodiment of the present invention.

This fourth embodiment is characterized by that, in contrast to the first embodiment, a transmission modulator 5d is provided with a transmission data clock input terminal. The transmission data clock is a signal which is transmitted by an external transmission data generator to the transmission modulator 5d to indicate a timing for determining the transmission data. The transmission modulator 5d determines the transmission data at a timing synchronized with a rising or falling of the data clock, and calculates a division number change amount according to the data.

In the case of the transmission modulation using the binary transmission data, the transmission frequency modulation can be performed if the change in the transmission data can be continuously detected even without a data clock. Further, also in the case of the frequency modulation using the multiple-value transmission data, when the plural-bits transmission data are inputted independently 1 bit by 1 bit from the signal lines as many as the number of bits, the transmission frequency modulation can be performed by continuously detecting the changes in the transmission data of the respective bits in similar manner.

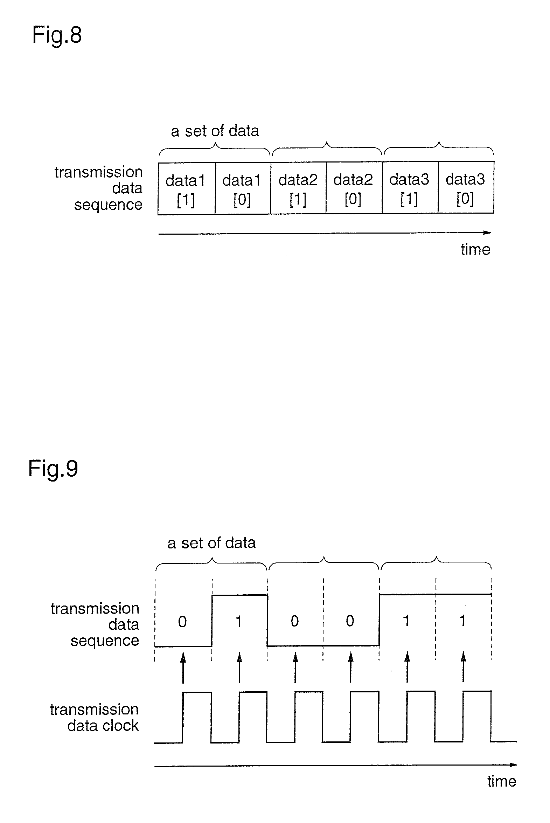

However, there is a case where, because of a restriction on the number of terminals, the plural-bits transmission data must be serially transmitted using a 1-bit transmission data input line as shown in figure 8. In this case, the transmission modulator 5d cannot distinguish between no change in the signal and a break of bits, by only the transmission data.

For example, as shown in figure 9, when {01},{00},{11} are desired to be transmitted successively as 2-bit transmission data, the transmission data is falsely recognized as {01},{01} if only the change in the transmission data is detected. When such false recognition occurs, the communication cannot be normally performed.

So, the data clock is transmitted together with the transmission data, and the transmission data is determined at the timings shown in the arrows in figure 9, whereby the bit breaks can be clarified and the multiple-bit transmission data can be normally recognized.

Figure 7(b) is a diagram illustrating a specific construction of the transmission modulator 5d in the frequency synthesizer of this fourth embodiment. In the figure, the same reference numerals as those shown in figure 1(b) denote the same or corresponding parts. Further, reference numeral 58 denotes a parallel transmission data generation circuit, and numeral 59 denotes a transition frequency width calculation circuit.

The transmission data TD is serially inputted in synchronization with the transmission data clock TDCL to the transmission modulator 5d in the frequency synthesizer of the fourth embodiment. The transmission data inputted to the parallel transmission data generation circuit 58 is determined at the timing of the transmission data clock TDCL, and inputted as parallel transmission data TDp to the transition frequency width calculation circuit 59. The transition frequency width calculation circuit 59 calculates a transition frequency width Fdev on the basis of the parallel-inputted transmission data TDp and the transmission data value setting signal TDs. Since the operation after the calculation of the transition frequency width Fdev is identical to the operation of the transmission modulator 5b of the frequency synthesizer of the first embodiment shown in figure 1(b), repeated description is not necessary.

In the frequency synthesizer 400 of this fourth embodiment, the transmission modulator 5d is provided with the transmission data clock input terminal, and the data clock is transmitted together with the transmission data, and thereby the transmission data is determined at the timing given by the data clock to clarify the bit breaks. Therefore, also the multiple-bit transmission data can be normally recognized, and thus the multiple-value frequency modulation can be realized even in the state where the transmission data input line is a 1-bit input line.

(Embodiment 5)

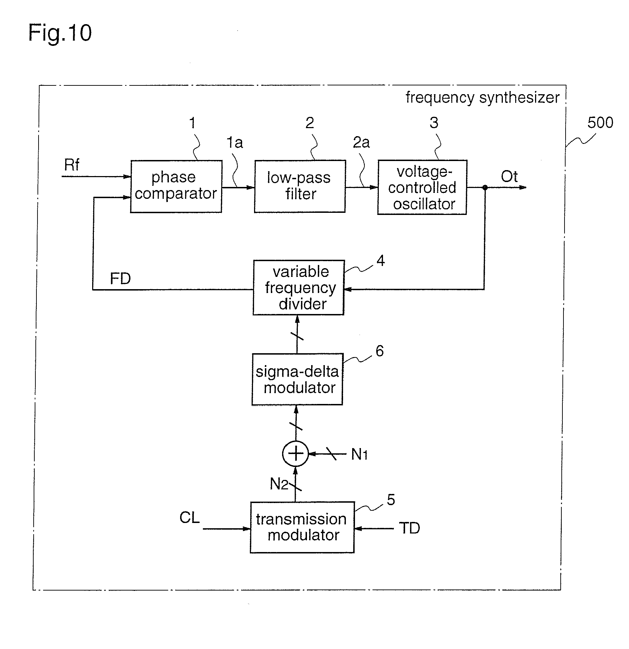

Figure 10 is a diagram illustrating the construction of a frequency synthesizer 500 according to a fifth embodiment of the present invention.

This fifth embodiment is characterized by that a sigma-delta (delta-sigma) modulator 6 is provided in the frequency synthesizer of the first embodiment.

The sigma-delta modulator 6 sigma-delta-modulates the division number data to which the division number change amount corresponding to the transmission data is added, and outputs the resultant data as a division number input to the variable frequency divider. By performing the sigma-delta modulation, quantization noise that occurs in the fractional frequency division can be diffused to the higher frequency side.

In the frequency synthesizer, the noise in the vicinity of the oscillation frequency causes undesirable influences such as leakage to the adjacent channel. However, by diffusing the quantization noise toward the higher frequency side, it becomes possible to remove the noise component with a filter, thereby realizing a frequency synthesizer having a highly-precise frequency spectrum.

In the frequency synthesizer 500 of this fifth embodiment, the frequency synthesizer of the first embodiment is provided with the sigma-delta modulator 6. The division number data to which the division number change amount corresponding to the transmission data is added is sigma-delta-modulated by this sigma-delta modulator 6 to be outputted as a division number input to the variable frequency divider, and the quantization noise that occurs in the fractional frequency division is diffused toward the higher-frequency side by this sigma-delta modulation to make the noise component removable with a filter, resulting in a frequency synthesizer having a highly-precise frequency spectrum.

In the above description, the method of diffusing the quantization noise that occurs in the fractional frequency division is not restricted to the sigma-delta modulation method, and any other method may be adopted.

(Embodiment 6)

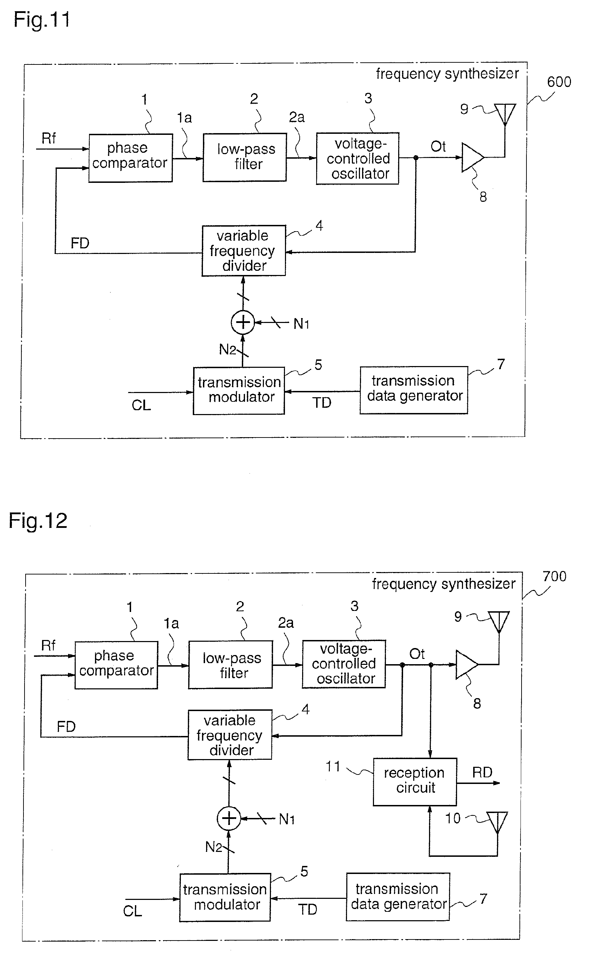

Figure 11 is a diagram illustrating the construction of a radio communication system 600 according to a sixth embodiment of the present invention.

The radio communication system 600 of this sixth embodiment is characterized by that the frequency synthesizer 100 of the first embodiment is provided with a transmission data generator 7 for generating transmission data, a power amplifier 8 for amplifying the power of an output signal from the frequency synthesizer 100, and a transmission antenna 9 for radio-transmitting the signal amplified by the power amplifier 8.

A radio communication system having a transmission frequency modulation function can be realized inexpensively by forming the radio communication system 600 of this sixth embodiment on the same semiconductor substrate. Further, by changing the transmission frequency for a short time and immediately restoring it to the original frequency, only the phase of the transmission signal can be changed with its frequency being fixed. By utilizing this effect, the amplification degree of the power amplifier 8 is changed simultaneously with performing the phase modulation, thereby realizing polar modulation that performs the phase modulation and the amplitude modulation simultaneously.

In the radio communication system 600 of this sixth embodiment, the frequency synthesizer 100 of the first embodiment is provided with the transmission data generator 7 for generating transmission data, the power amplifier 8 for amplifying the power of the output signal outputted from the frequency synthesizer 100, and the transmission antenna 9 for radio-transmitting the signal amplified by the power amplifier 8, and these constituents are formed on the same semiconductor substrate. Therefore, it is possible to inexpensively realize a radio communication system having a transmission frequency modulation function.

Further, by changing the transmission frequency for a short time and immediately restoring it to the original frequency, only the phase of the transmission signal can be changed with its frequency being fixed. By utilizing this effect, the amplification degree of the power amplifier 8 is changed simultaneously with performing the phase modulation, thereby realizing polar modulation that performs the phase modulation and the amplitude modulation simultaneously.

(Embodiment 7)

Figure 12 is a diagram illustrating the construction of a radio communication system 700 according to a seventh embodiment of the present invention.

This seventh embodiment is characterized by that the radio communication system of the sixth embodiment is further provided with a reception antenna 10 which receives the transmitted radio signal, and a reception circuit 11 which extracts the transmitted data from the radio signal received by the reception antenna 10.

During the receiving operation, the frequency synthesizer performs no frequency modulation, and continuously outputs a constant frequency for each reception channel as a local oscillator.

By integrating the radio communication system 700 of this seventh embodiment on a single semiconductor substrate, a radio communication system having a transmission frequency modulation function and a reception function can be realized inexpensively.

In the radio communication system 700 of this seventh embodiment, the radio communication system 600 of the sixth embodiment is provided with the reception antenna 10 which receives the transmitted radio signal, and the reception circuit 11 which extracts the transmitted data from the radio signal received by the reception antenna 10. Therefore, by integrating this radio communication system on a single semiconductor substrate, a radio communication system having a transmission frequency modulation function and a reception function can be realized inexpensively.

(Embodiment 8)

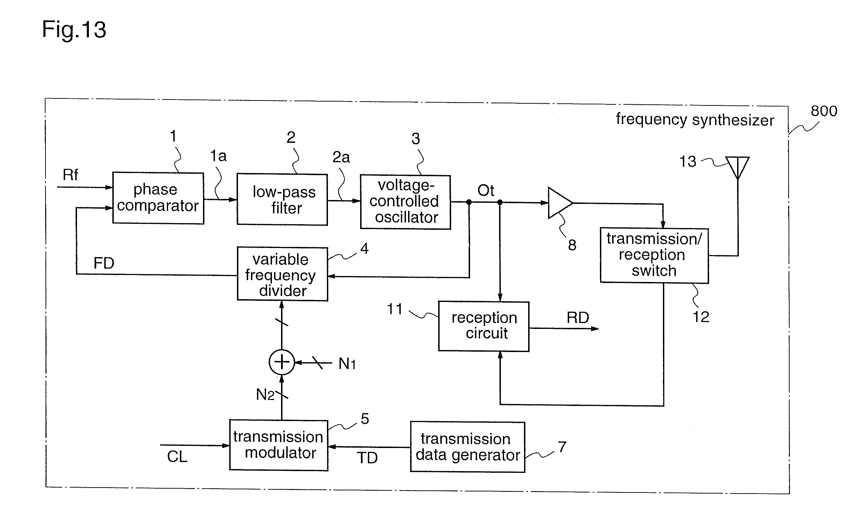

Figure 13 is a diagram illustrating the construction of a radio communication system 800 according to an eighth embodiment of the present invention.

This eighth embodiment is characterized by that the transmission antenna and the reception antenna are commonized as a transmission/reception antenna 13 by using a transmission/reception switch 12 that is called a duplexer, while in the seventh embodiment these antennae 9 and 10 are independently constituted. Thereby, the number of components can be reduced, and a radio communication system having a transmission frequency modulation function and a reception function can be realized inexpensively.

In the radio communication system 800 of this eighth embodiment, the transmission antenna and the reception antenna are commonized as the transmission/reception antenna 13 by using the transmission/reception switch that is called a duplexer. Therefore, the number of components can be reduced, and thereby a radio communication system having a transmission frequency modulation function and a reception function can be realized inexpensively.

APPLICABILITY IN INDUSTRY

According to the frequency synthesizer, the radio communication system, or the semiconductor device of the present invention, highly-precise and highly-functional transmission frequency modulation is realized with a reduced circuit area, and it is applicable to every radio communication LSI which performs communication by frequency modulation or FSK modulation. Especially, a profound effect can be obtained in the radio communication system having a variety of communication modes for the change width of a transmission frequency or the number of bits of transmission data.

**Claims**

1. A frequency synthesizer comprising:

   a voltage-controlled oscillator which generates a signal having a frequency corresponding to an inputted control voltage;
   a variable frequency divider which frequency-divides the output signal from the voltage-controlled oscillator according to inputted division number data to output the frequency-divided signal;
   a phase comparator which compares the phase of the output signal from the variable frequency divider with the phase of an inputted reference signal, and generates and outputs a signal indicating the comparison result;
   a low-pass filter which low-pass-filters the signal from the phase comparator to output the filtered signal as the control voltage for the voltage-controlled oscillator; and
   a transmission modulator which calculates a division number change amount of the variable frequency divider in accordance with the inputted transmission data, and adds the calculated division number change amount to a division number set value of a center frequency, thereby performing frequency modulation.

2. A frequency synthesizer as defined in Claim 1 wherein
   said transmission modulator, provided with a clock signal input terminal, performs the frequency modulation with dividing the frequency modulation process into plural steps using a clock signal supplied from the clock signal input terminal, and calculates the division number change amounts corresponding to the respective steps.

3. A frequency synthesizer as defined in Claim 2 wherein
   the clock signal which is used for dividing the frequency modulation process into plural steps is a clock signal having a constant frequency.

4. A frequency synthesizer as defined in Claim 1 wherein
   said transmission modulator calculates the division number change amounts corresponding to the multiple-value frequency modulation having plural-bits transmission data.

**5.** A frequency synthesizer as defined in Claim 4 wherein
the transmission data have the transmission data values for the multiple-value frequency modulation.

**6.** A frequency synthesizer as defined in Claim 4 wherein
the plural-bits transmission data are sequentially inputted to the transmission modulator through a 1-bit input terminal.

**7.** A frequency synthesizer as defined in Claim 1 wherein
said transmission modulator, provided with a transmission data clock input terminal, judges the value of the transmission data at a timing synchronized with a transmission data clock that is supplied from the transmission data clock input terminal.

**8.** A frequency synthesizer as defined in Claim 1 wherein
said transmission modulator sets the frequency change amount for the frequency modulation to plural patterns, and calculates the division number change amounts corresponding to the respective frequency change amounts.

**9.** A frequency synthesizer as defined in Claim 1 further including a sigma-delta modulator which sigma-delta-modulates the division number data that is modulated by the transmission modulator, and outputs the same to the variable frequency divider.

**10.** A radio communication system comprising:

a frequency synthesizer as defined in Claim 1;
a power amplifier which amplifies the output signal of the voltage-controlled oscillator;
a transmission antenna which transmits the signal that is amplified by the power amplifier;
a transmission data generator which generates transmission data and sends the same to the frequency synthesizer; and
said transmission data signal that is frequency-modulated by the frequency synthesizer being radio-transmitted from the transmission antenna.

**11.** A radio communication system as defined in Claim 10 wherein
the output level of the power amplifier is made variable to simultaneously perform the phase modulation and amplitude modulation of the transmission signal.

**12.** A radio communication system as defined in Claim 11 further including
a reception antenna which receives a transmitted radio signal, and
a reception circuit which extracts the transmitted data from the radio signal that is received by the reception antenna.

**13.** A radio communication system as defined in Claim 12 further including a transmission/reception switching unit which selects the transmission antenna and the reception antenna at transmission and reception, respectively.

**14.** A semiconductor device having integrated on a single semiconductor substrate a radio communication system as defined in any of Claims 10 to 13.

Fig.1(a)

# Fig.1(b)

Fig.2(a)

frequency

center frequency+Fdev

center frequency

center frequency-Fdev

time

Fig.2(b)

frequency

center frequency+Fdev

center frequency

center frequency-Fdev

time

## Fig.3(a)

EP 2 009 797 A1

## Fig.3(b)

EP 2 009 797 A1

# Fig.4(a)

frequency synthesizer 200

Rf → phase comparator (1) → 1a → low-pass filter (2) → 2a → voltage-controlled oscillator (3) → Ot

FD ← variable frequency divider (4)

$\oplus$ ← N1

N2 ← 5b

CL → transmission modulator → TD (501), TDs (502)

Fig.4(b)

## Fig.5

## Fig.6(a)

Fig.6(b)

5c

TD

Fdevs

57 transition frequency width data table

Rf

Fdev

52 multiplier

ΔN

53 plural step division coefficient calculation circuit

ΔN(n)

Sn

55 time measurement counter

CL

54 plural step division time interval calculation circuit

Si

Sc

Fig.7(a)

frequency synthesizer 400

phase comparator — 1

low-pass filter — 2

voltage-controlled oscillator — 3

Rf → phase comparator → 1a → low-pass filter → 2a → voltage-controlled oscillator → Ot

FD ← variable frequency divider — 4

N1

N2 — 5d — 501

CL → transmission modulator ← TD, ← TD_CL

504

Fig.7(b)

Fig.8

a set of data

| transmission data sequence | data1 [1] | data1 [0] | data2 [1] | data2 [0] | data3 [1] | data3 [0] |
|---|---|---|---|---|---|---|

time

Fig.9

a set of data

transmission data sequence

0   1   0   0   1   1

transmission data clock

time

Fig.10

frequency synthesizer

500

Rf → phase comparator (1) →1a→ low-pass filter (2) →2a→ voltage-controlled oscillator (3) → Ot

FD → variable frequency divider (4)

sigma-delta modulator (6)

⊕ ← N1

N2

CL → transmission modulator (5) ← TD

Fig.11

Fig.12

Fig.13

frequency synthesizer 800

phase comparator 1

low-pass filter 2

voltage-controlled oscillator 3

variable frequency divider 4

transmission modulator 5

transmission data generator 7

reception circuit 11

transmission/reception switch 12

13

8

Rf

1a

2a

Ot

FD

RD

N1

N2

TD

CL

## INTERNATIONAL SEARCH REPORT

| International application No. |
| --- |
| PCT/JP2007/054237 |

A.   CLASSIFICATION OF SUBJECT MATTER
*H03L7/183(2006.01)i, H04L27/34(2006.01)i*

According to International Patent Classification (IPC) or to both national classification and IPC

B.   FIELDS SEARCHED

Minimum documentation searched (classification system followed by classification symbols)
H03L7/183, H04L27/34

Documentation searched other than minimum documentation to the extent that such documents are included in the fields searched
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
| --- | --- | --- |
| Y<br>A | JP 2005-72876 A  (Matsushita Electric<br>Industrial Co., Ltd.),<br>17 March, 2005 (17.03.05),<br>Par. No. [0004]; Fig. 10<br>& US 2006/55467 A1      & EP 1657812 A1<br>& WO 2005/20429 A1 | 1,7,9-14<br>2-6,8 |
| Y<br>A | JP 2005-277459 A  (Toshiba Corp.),<br>06 October, 2005 (06.10.05),<br>Par. No. [0025]<br>(Family: none) | 1,7,9-14<br>2-6,8 |
| Y<br>A | JP 2004-260411 A  (Matsushita Electric<br>Industrial Co., Ltd.),<br>16 September, 2004 (16.09.04),<br>Par. Nos. [0024] to [0029]; Fig. 1<br>& US 2004/198418 A1 | 10-14<br>1-9 |

| ☒   Further documents are listed in the continuation of Box C. | ☐   See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>22 May, 2007 (22.05.07) | Date of mailing of the international search report<br>05 June, 2007 (05.06.07) |
| --- | --- |
| Name and mailing address of the ISA/<br>Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2007/054237

C (Continuation).   DOCUMENTS CONSIDERED TO BE RELEVANT

| Category* | Citation of document, with indication, where appropriate, of the relevant passages | Relevant to claim No. |
|---|---|---|
| Y<br>A | JP 2004-201123 A  (Hitachi Kokusai Electric Inc.),<br>15 July, 2004 (15.07.04),<br>Par. Nos. [0010] to [0021]; Fig. 1<br>(Family: none) | 11-14<br>1-10 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

• *IEEE FOURNAL OF SOLID-STATE CIRCUITS,* July 1998, vol. 33 (7), 998